(19) Europäisches Patentamt
European Patent Office
Office européen des brevets

(11) **EP 2 483 943 B1**

(12) **EUROPÄISCHE PATENTSCHRIFT**

(45) Veröffentlichungstag und Bekanntmachung des Hinweises auf die Patenterteilung:
**04.11.2015 Patentblatt 2015/45**

(21) Anmeldenummer: **10760674.1**

(22) Anmeldetag: **29.09.2010**

(51) Int Cl.:
**_H01L 51/52_** _(2006.01)_

(86) Internationale Anmeldenummer:
**PCT/EP2010/064494**

(87) Internationale Veröffentlichungsnummer:
**WO 2011/039277 (07.04.2011 Gazette 2011/14)**

(54) **OPTOELEKTRONISCHES ORGANISCHES BAUELEMENT UND VERFAHREN ZU DESSEN HERSTELLUNG**

OPTOELECTRONIC ORGANIC COMPONENT AND METHOD FOR THE PRODUCTION THEREOF

COMPOSANT ORGANIQUE OPTOÉLECTRONIQUE ET PROCÉDÉ DE FABRICATION CORRESPONDANT

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(30) Priorität: **30.09.2009 DE 102009047883**

(43) Veröffentlichungstag der Anmeldung:
**08.08.2012 Patentblatt 2012/32**

(73) Patentinhaber: **OSRAM OLED GmbH**
**93049 Regensburg (DE)**

(72) Erfinder:
• **PHILIPPENS, Marc**
**93049 Regensburg (DE)**
• **PÄTZOLD, Ralph**
**91154 Roth (DE)**

• **SARFERT-GAST, Wiebke**
**91074 Herzogenaurach (DE)**
• **HARTMANN, David**
**Erlangen 91056 (DE)**
• **HUNZE, Arvid**
**5014 Wainuiomata / Lower Hutt, (NZ)**
• **KRAUSE, Ralf**
**91074 Herzogenaurach (DE)**

(74) Vertreter: **Epping - Hermann - Fischer Patentanwaltsgesellschaft mbH Schloßschmidstraße 5 80639 München (DE)**

(56) Entgegenhaltungen:
**EP-A1- 1 643 812       EP-A2- 2 045 847**
**US-A1- 2007 126 348**

**Beschreibung**

Es wird ein optoelektronisches organisches Bauelement nach dem Anspruch 1 angegeben.

Ein weit verbreitetes Problem bei der Herstellung von optoelektronischen organischen Bauelementen ist, dass auf der Oberfläche der Elektroden, welche in das Innere des Bauelements weisen, kleine Partikel oder andere Verunreinigungen angelagert sein können, oder die Oberfläche beispielsweise Metallspitzen aufweisen kann. Dies kann beispielsweise die Ursache für mögliche lokale Kurzschlüsse beziehungsweise lokale hochohmige Strompfade im Bauelement sein. Eine bisher genutzte Möglichkeit, dieses Problem zu beheben, besteht darin die Oberfläche einem sehr aufwändigen Reinigungsverfahren zu unterwerfen. Ein anderer Lösungsansatz liegt darin eine dicke Schicht über der Elektrode aufzutragen, welche beispielsweise die Metallspitzen bedeckt. Bei solchen Schichten tritt allerdings das Problem auf, dass es zu statistischen Streuungen in den Strom-Spannungskennlinien kommt. Ein Grund hierfür liegt in den lokalen Schichtdickenschwankungen, welche beispielsweise durch die Verunreinigungen verursacht werden. Hieraus können sich wiederum Widerstandsschwankungen ergeben, die sich nachteilig auf die Prozessstabilität auswirken.

Eine Aufgabe von Ausführungsformen der Erfindung besteht darin, ein optoelektronisches organisches Bauelement bereitzustellen, bei dem die statistische Streuung in der Strom-Spannungskennlinie bei einer Vielzahl dieser Bauelemente vermindert ist.

Die Aufgabe wird durch ein optoelektronisches organisches Bauelement nach dem Anspruch 1 gelöst. Weitere Ausführungsformen des optoelektronischen organischen Bauelements sind Gegenstand weiterer abhängiger Patentansprüche.

Eine Ausführungsform der Erfindung betrifft ein optoelektronisches organisches Bauelement nach Anpruch 1.

Durch die gezielte Kombination der ersten Planarisierungsschicht mit der ersten Injektionsschicht kann die statistische Streuung in den Strom-Spannungskennlinien deutlich gesenkt werden. Durch ein gezieltes Abstimmen der Energieniveaus der ersten Planarisierungsschicht, der ersten Injektionsschicht und der organischen Funktionsschicht kommt es zur Ausbildung eines internen Reservoirs. Die Ladungsträger, welche im Betrieb des optoelektronischen organischen Bauelements von der ersten Elektrode abgegeben werden, wandern durch die erste Planarisierungsschicht in die erste Injektionsschicht. Aufgrund der Energieniveaus bildet sich in der ersten Injektionsschicht ein Potenzialtopf aus, in dem sich die Ladungsträger sammeln können. Durch dieses durch den Potenzialtopf der Injektionsschicht gebildete interne Reservoir, welches innerhalb des optoelektronischen organischen Bauelements liegt, also zwischen den beiden Elektroden des Bauelements, können somit lokale Widerstandsschwankungen der Elektroden oder der Planarisierungsschicht ausgeglichen werden. Der Ladungsträgertransport innerhalb des Bauelements kann hierdurch stabilisiert und eventuell auftretende Feld- und Widerstandsschwankungen können ausgeglichen werden. Der Potenzialtopf stellt gewissermaßen eine eigene Quelle für Ladungsträger dar, die in der Lage ist während des Betriebes des Bauelements Ladungsträger in einer konstanten Menge an eine definierte Fläche an die darauf folgende organische Funktionsschicht abzugeben. Somit kann trotz möglicher Verunreinigungen oder Metallspitzen auf den Innenseiten der Elektroden ein stabiler Ladungstransport in dem Bauelement erzielt werden.

Für die Erfindung gilt, dass es sich bei der ersten Elektrode um eine Anode handelt und für die Energieniveaus: $E_F - E_{HOMO,Plan.} < E_F - E_{HOMO, Funk.}$

Durch eine entsprechende Abstimmung der Energieniveaus kann die Höhe der "Seitenwände" des Potenzialtopfes bestimmt werden. Diese Höhe der Seitenwände gibt energetisch den Widerstand an, die ein Ladungsträger überwinden muss, um in die nächste angrenzende Schicht zu gelangen. Wählt man diesen Widerstand ausreichend hoch, so wird dadurch sichergestellt, dass sich im Potenzialtopf ausreichend Ladungsträger sammeln, was zur Folge hat, dass jederzeit Ladungsträger in der Injektionsschicht zur Injektion in die darauf folgende Schicht zur Verfügung stehen. Somit kann eine zeitlich und/oder räumlich gleichmäßige und konstante Abgabe von Ladungsträgern erreicht werden. Über die Höhe der Seitenwände kann somit auch das "Fassungsvermögen" an Ladungsträgern des Potentialtopfes eingestellt werden.

In einer Ausführungsform der Erfindung werden die von der ersten Elektrode abgegebenen Ladungsträger in der ersten Injektionsschicht akkumuliert. Das bedeutet, dass die Ladungsträgerdichte im Betrieb des optoelektronischen organischen Bauelements in der Injektionsschicht höher ist als in den zu ihr direkt benachbarten Schichten.

In einer weiteren Ausführungsform der Erfindung werden die in der ersten Injektionsschicht akkumulierten Ladungsträger in die darauf folgende Schicht injiziert.

Die Injektion der akkumulierten Ladungsträger in die darauf folgende Schicht stellt sicher, dass die darauf folgende Schicht fortwährend und konstant mit dem Ladungsträger versorgt wird, wodurch der Ladungstransport im Bauelement stabilisiert wird.

Zum Beispiel gilt für die Widerstände R der ersten Planarisierungsschicht ($R_{Plan.}$) und der ersten Injektionsschicht ($R_{Inj.}$), sowie für den Grenzflächenwiderstand durch Kontakt zwischen der ersten Planarisierungsschicht und der ersten Injektionsschicht ($R_{Kontakt,Inj.}$) und den Grenzflächenwiderstand durch Kontakt zwischen der erster Injektionsschicht und der organischer Funktionsschicht ($R_{Kontakt,Funk.}$) die Bedingung: $R_{Plan.} + R_{Kontakt,Inj} \leq R_{Inj.} + R_{Kontakt,Funk.}$

Hierbei liegt der Widerstand der Planarisierungsschicht vorzugsweise im Bereich des Widerstandes der Injektionsschicht.

In einer weiteren Ausführungsform der Erfindung weist die erste Injektionsschicht eine Schichtdicke von 1 bis 20 nm auf.

Hierbei ist der Bereich von 1 bis 3 nm bevorzugt. Bereits eine sehr dünne Injektionsschicht kann zur deutlichen Stabilisierung des Ladungsträgertransports beitragen. Dies hat den Vorteil, dass auf die bereits dickere Planarisierungsschicht nicht nochmals eine sehr dicke Schicht aufgetragen werden muss, was eine deutliche Vergrößerung des Bauelements hinsichtlich seiner Gesamtdicke zur Folge haben würde.

Ein weiterer bevorzugter Bereich ist 3 bis 20 nm. Eine Schicht dieser Dicke weist besonders gut Stabilisierungseigenschaften bezüglich des Ladungstransportes auf.

Erfindungsgemäß ist die erste Injektionsschicht p-dotiert.

Durch das Dotieren der Injektionsschicht können beispielsweise deren Energieniveaus gezielt eingestellt werden. Des Weiteren kann durch die Dotierung auch der Ladungsträgertransport bzw. die Ladungsträgerakkumulierung in der Injektionsschicht verbessert werden.

Der Dotierstoff ist ausgewählt aus: $MoO_2$, $MoO_3$, $WO_3$, $ReO_3$, $Re_2O_7$, $V_2O_5$. Diese Dotierstoffe werden vor-zugsweise als p-Dopanden verwendet.

Nicht beansprucht wird eine Ausführungsform, in der die erste Injektionsschicht eine Matrixmaterial umfasst, ausgewählt aus:

$Alq_3$ (LUMO -3,1eV), BCP (LUMO -2,9 eV), Bphen (LUMO -2,9 eV), NTCDA (LUMO -4,0 eV), ZnPc, THAP (LUMO -4,6 eV). Hierbei ist das Matrixmaterial mit einem der folgen Stoffe n-dotiert: Li, Cs, BEDT-TTF, Pyronin-B-chlorid, $Cs_2CO_3$, Ru (terpy)$_2$, CoCp$_2$. Hierbei steht "LUMO" für das niedrigste unbesetzte Molekülorbital.

In einer weiteren Ausführungsform der Erfindung umfasst die erste Injektionsschicht einen Stoff ausgewählt aus: 4,4',4"-Tris(N-(1-naphthyl)-N-phenyl-amino)triphenylamin, Phthalocyanin-Kupferkomplex, 4,4',4"-Tris(N-3-methylphenyl-N-phenyl-amino)triphenylamin, N,N'-Bis(naphthalen-1-yl)-N,N'-bis(phenyl)-benzidin, 2,2',7,7'-Tetrakis(N,N-diphenylamin)-9,9'-spirobifluoren, Di-[4-(N,N-ditolyl-amino)-phenyl]cyclohexan, N,N'-Bis(3-methylphenyl)-N,N'-bis(phenyl)-benzidin.

In der nachfolgenden Tabelle sind die Energieniveaus der jeweils höchsten besetzten Molekülorbitale (HOMOs) der jeweiligen Substanzen aufgeführt.

| | |
|---|---|
| 4,4',4"-Tris(N-(1-naphthyl)-N-phenyl-amino)triphenylamin | -5,0 eV |
| Phthalocyanin-Kupferkomplex | -5,2 eV |
| 4,4',4" -Tris(N-3-methylphenyl-N-phenyl-amino)triphenylamin | -5,0 eV |
| N,N'-Bis(naphthalen-1-yl)-N,N'-bis(phenyl)-benzidin | -5,5 eV |
| 2,2',7,7'-Tetrakis(N,N-diphenylamino)-9,9'-spirobifluoren | -5,4 eV |
| Di-[4-(N,N-ditolyl-amino)-phenyl]cyclohexan | -5,5 eV |
| N,N'-Bis(3-methylphenyl)-N,N'-bis(phenyl)-benzidin | -5,57 eV |

Die Lage der HOMOs kann beispielsweise mittels Zyklovoltammetrie bestimmt werden.

Die erste Injektionsschicht und die erste Planarisierungsschicht umfassen einen Stoff ausgewählt aus: PEDOT:PSS, Poly(9-vinylcarbazol), Poly(N,N'-bis(4-butylphenyl)-N,N'-bis(phenyl)-benzidin, Poly(3-hexylthiophen), Polyanilin.

In der nachfolgenden Tabelle sind die HOMO-Bereiche für drei dieser Stoffe angegeben:

| | |
|---|---|
| PEDOT:PSS | -5,0 bis -5,9 eV |
| Poly(N,N'-bis(4-butylphenyl)-N,N'-bis(phenyl)-benzidin | -5,1 bis -5,17 eV |
| Poly(3-hexylthiophen) | -5,23 eV |

Der genaue Energieniveauwert der einzelnen Schichten kann über die jeweilige Dotierung derselben eingestellt werden. Somit kann für die erste Injektionsschicht und die erste Planarisierungsschicht das gleiche Matrixmaterial verwendet werden, deren genaue Energieniveaus beispielsweise mittels eines Dotierstoffes eingestellt werden können.

Nicht beansprucht wird eine erste Planarisierungsschicht aus einem anorganischen Stoff.

Diese kann einen Stoff aufweisen ausgewählt aus: InO, GaO, ZnO, SnO, MoO, VO, SbO, BiO, ReO, TaO, WO, NbO, NiO.

Durch die Kenntnis der Energieniveaus der ersten Injektionsschicht beziehungsweise ersten

Planarisierungsschicht können diese durch Dotierung und/oder Materialauswahl und Materialmischung so aufeinander abgestimmt werden, dass die Energieniveaus in dem zuvor beschriebenen Verhältnis zueinander vorliegen. Entsprechendes gilt für die Abstimmung der Energieniveaus von erster Injektionsschicht und organischer Funktionsschicht.

Die angeführten Stoffe lassen sich auch gut auf der Elektrode als Planarisierungsschicht beziehungsweise auf der Planarisierungsschicht als Injektionsschicht auftragen.

In einer weiteren Ausführungsform der Erfindung ist die erste Planarisierungsschicht direkt auf der ersten Elektrode angeordnet. Die erste Planarisierungsschicht weist dabei eine Dicke auf, die größer als die Höhe von Unebenheiten auf der ersten Elektrode ist. Hierdurch ist es möglich, mittels der ersten Planarisierungsschicht die Unebenheiten auf der ersten Elektrode auszugleichen.

Des Weiteren umfasst das optoelektronische Bauelement zusätzlich:

- eine zweite Planarisierungsschicht, welche zwischen der zweiten Elektrode und der organischen Funktionsschicht angeordnet ist,
- eine zweite Injektionsschicht, welche zwischen der zweiten Planarisierungsschicht und der organischen Funktionsschicht angeordnet ist.

Dabei weisen beide Elektroden jeweils eine Planarisierungsschicht auf und zwischen beiden Planarisierungsschichten und der organischen Funktionsschicht ist jeweils eine Injektionsschicht angeordnet. Hierdurch werden sowohl die Abgabe von Elektronen von der Kathode wie auch die Abgabe von Löchern von der Anode zur organischen Funktionsschicht jeweils von einer Injektionsschicht stabilisiert. Eine solche Ausführungsform weist somit einen besonders stabilen Ladungsträgertransport auf.

In einer Ausführungsform der Erfindung ist das optoelektronische organische Bauelement als elektrolumineszierendes Bauelement ausgeformt.

Hierbei kann es sich beispielsweise um eine organische Leuchtdiode (OLED) handeln. Der Schichtenstapel, welcher eine OLED ausbilden kann, umfasst eine Anode sowie eine Kathode. Von diesen werden durch Anlegen einer Spannung Löcher bzw. Elektroden abgegeben, welche in Richtung der jeweils anderen Elektrode wandern. Die Ladungsträger wandern hierbei beispielsweise erst durch löcher- bzw. elektronentransportierende Schichten, bevor sie in einer lichtemittierenden Schicht aufeinandertreffen. In dieser bilden die Elektronen mit den Löchern Excitonen aus. Die Excitonen können Leuchtstoffe, welche sich in der emittierenden Schicht befinden, zur Abgabe von Strahlung anregen. Die OLED kann eine organische Funktionsschicht umfassen, bei der es sich beispielsweise um eine lichtemittierende, ladungsträgerblockende oder ladungsträgertransportierende Schicht oder eine Kombination daraus handeln kann.

Zumindest eine weitere Ausführungsform der Erfindung betrifft ein Verfahren zur Herstellung eines optoelektronischen organischen Bauelements.

In einer Ausführungsform zur Herstellung eines optoelektronischen organischen Bauelements umfasst das Verfahren die Verfahrensschritte nach Anspruch 8.

Weiterhin kann das Verfahren Merkmale und Schritte aufweisen, durch die ein optoelektronisches organisches Bauelement mit einem oder mehreren der vorgenannten Merkmale herstellbar ist.

Die erste Planarisierungsschicht kann im Verfahrensschritt B) auf die erste Elektrode mittels Gasphasenabscheidung oder mittels eines nasschemischen Prozesses aufgebracht werden.

Durch die erste Planarisierungsschicht werden Verunreinigungen wie beispielsweise Staub, Glas, Metall oder organische Partikel, welcher sich auch trotz Reinigung noch auf der Elektrode befinden kann, abgedeckt. Des Weiteren wird die erste Planarisierungsschicht mit einer derartigen Dicke aufgebracht, dass sie Metallspitzen der Elektrode umschließt und überdeckt, welche beispielsweise durch eine Sputtertechnik zur Herstellung der ersten Elektrode entstehen können. Hierdurch werden eventuelle Feldüberhöhungen des sich im Betrieb des optoelektronischen organischen Bauelements ausbildenden elektrischen Feldes zwischen den Elektroden abgeschwächt und somit der elektrische Einschluss dieser Verunreinigungen reduziert. Durch das Aufbringen der ersten Injektionsschicht im Verfahrensschritt C) und der organischen Funktionsschicht im Verfahrensschritt D) mit den geeigneten Energieniveaus kommt es zur Ausbildung des Potenzialtopfes in der oben beschriebenen Form. Sowohl die erste Injektionsschicht wie auch die organische Funktionsschicht können sowohl mittels Gasphasenabscheidung als auch mit Hilfe eines nasschemischen Prozesses aufgebracht werden.

In einer weiteren Variante des Verfahrens wird die erste Injektionsschicht im Verfahrensschritt C) mittels eines nasschemischen Verfahrens aufgebracht.

In einer weiteren Variante des Verfahrens wird die erste Planarisierungsschicht im Verfahrensschritt B) mittels eines nasschemischen Verfahrens aufgebracht.

In einer weiteren Variante des Verfahrens wird die organische Funktionsschicht im Verfahrensschritt D) mittels eines nasschemischen Verfahrens aufgebracht.

Durch den Einsatz von nasschemischen Prozessen können die Prozesskosten gesenkt werden. Die Schichten können beispielsweise über Spincoat-, Rakel- oder Druckverfahren aufgebracht werden. Hierzu können beispielsweise lösungsbasierte organische Materialien verwendet werden.

Alternativ können die erste Injektionsschicht, die erste Planarisierungsschicht und die organische Funktionsschicht, jeweils unabhängig voneinander, auch aus der Gasphase abgeschieden werden.

Das Verfahren umfasst die Verfahrensschritte:

F) Aufbringen einer zweiten Injektionsschicht auf die organische Funktionsschicht,
G) Aufbringen einer zweiten Planarisierungsschicht auf die zweite Injektionsschicht.

Dabei werden die Schritte F) und G) vor dem Verfahrensschritt E) ausgeführt.

Ein Bauelement, welches nach dem Verfahren nach Anspruch 8 hergestellt wurde, umfasst somit auf beiden Elektroden jeweils der organischen Funktionsschicht zugewandt eine Planarisierungsschicht sowie eine Injektionsschicht.

In einer weiteren Variante des Verfahrens wird die zweite Injektionsschicht im Verfahrensschritt F) mittels eines nasschemischen Verfahrens aufgebracht.

In einer weiteren Variante des Verfahrens wird die zweite Planarisierungsschicht im Verfahrensschritt G) mittels eines nasschemischen Verfahrens aufgebracht.

Alternativ können die zweite Injektionsschicht und die zweite Planarisierungsschicht, jeweils unabhängig voneinander, auch aus der Gasphase abgeschieden werden.

Weitere Vorteile und vorteilhafte Ausführungsformen und Weiterbildungen der Erfindung ergeben sich aus den im Folgenden in Verbindung mit den Figuren 1a bis 6b beschriebenen Ausführungsformen.

Die Figuren 1a bis d zeigen jeweils einen schematischen Querschnitt von beispielhaften Ausführungsformen.

Die Figuren 2a bis d zeigen jeweils einen schematischen Querschnitt von Ausführungsformen der Erfindung, welche eine zweite Planarisierungsschicht und eine zweite Injektionsschicht umfassen.

Die Figuren 3a und b zeigen jeweils Energieschemata der beteiligten Schichten in optoelektronischen organischen Bauelementen von Ausführungsformen der Erfindung.

Die Figur 4 zeigt fünf Strom-Spannungskennlinien von organischen Bauelementen.

Die Figuren 5a und b zeigen in einer Gegenüberstellung die Kennlinie von einem Bauelement gemäß einer Ausführungsform mit erster Injektionsschicht verglichen mit einem nicht erfindungsgemäßen Bauelemente ohne erster Injektionsschicht mit einem ersten Polymer.

Die Figuren 6a und b zeigen in einer Gegenüberstellung die Kennlinie von einem Bauelement gemäß einer Ausführungsform mit erster Injektionsschicht verglichen mit einem nicht erfindungsgemäßen Bauelement ohne erster Injektionsschicht mit einem zweiten Polymer.

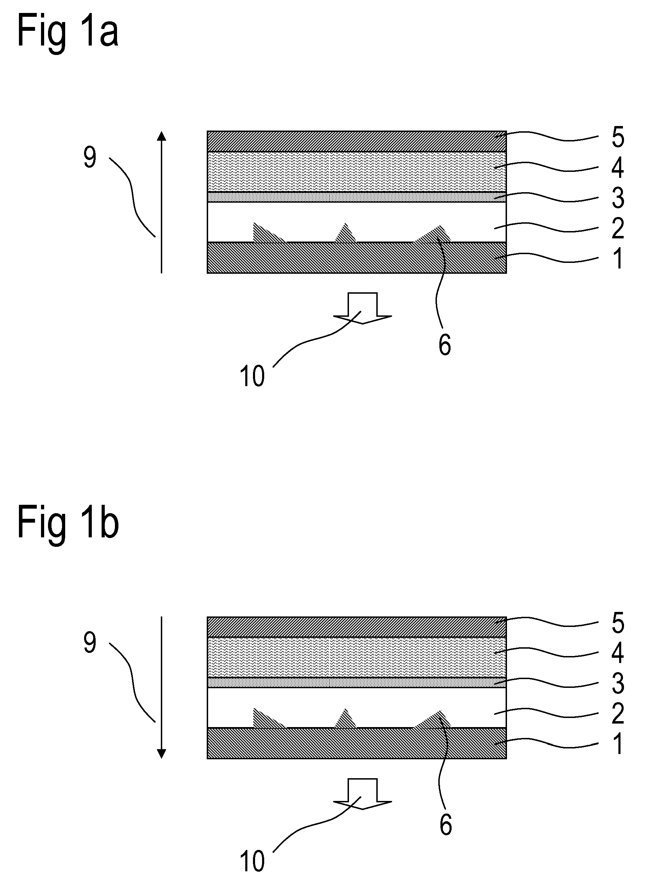

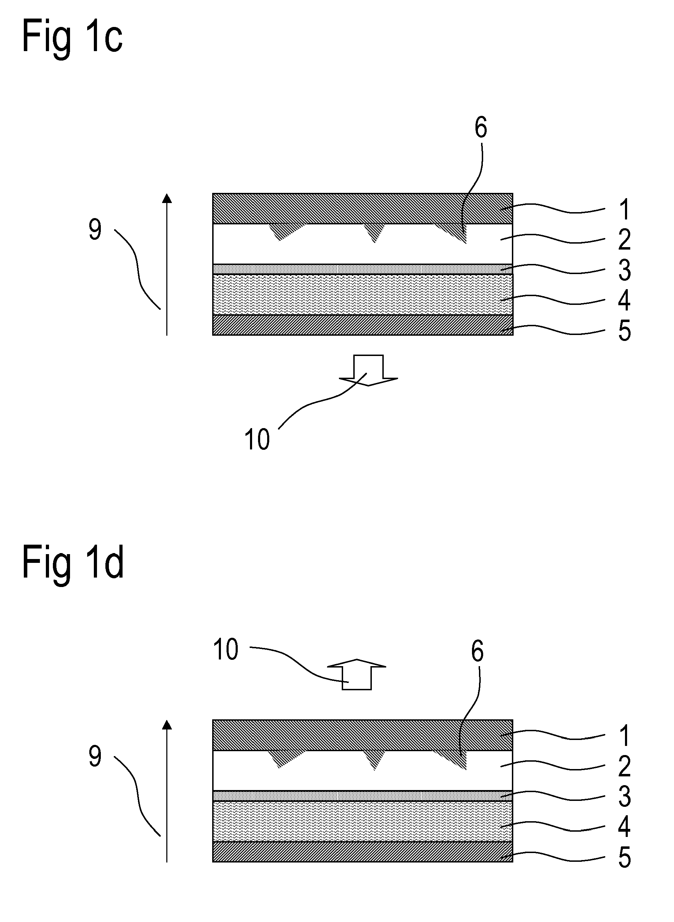

Die Figuren 1a bis d zeigen jeweils ein Ausführungsbeispiel in einem schematischen Querschnitt. Der Pfeil 9 jeweils links neben dem Schichtenstapel zeigt die Reihenfolge an, in welcher die Schichten aufeinander aufgebracht werden. Dieser kann beispielsweise nach einem der oben beschriebenen Verfahren in den Verfahrensschritten A) bis E) erfolgen. Der Blockpfeil 10 unter beziehungsweise über den Bauelementen zeigt die Richtung der Lichtemission des jeweiligen Bauelements an. Jedes der vier Ausführungsbeispiele umfasst eine Schichtenfolge umfassend eine erste Elektrode 1, welche auf ihrer Oberfläche Unebenheiten 6 aufweist, die durch Verunreinigungen oder Oberflächenstrukturen der Elektrodenoberfläche gebildet werden können. Diese werden durch eine darauf angeordnete erste Planarisierungsschicht 2 überdeckt und damit ausgeglichen. Auf die erste Planarisierungsschicht 2 folgt jeweils eine verglichen zu dieser dünnere erste Injektionsschicht 3. Zusammen mit der darauf folgenden organischen Funktionsschicht 4 kommt es in der ersten Injektionsschicht 3 durch die geeignete Wahl der Materialien zur Ausbildung eines Potenzialtopfes in der im allgemeinen Teil beschriebenen Art und Weise. Die Schichtenfolge umfasst des Weiteren noch eine zweite Elektrode 5.

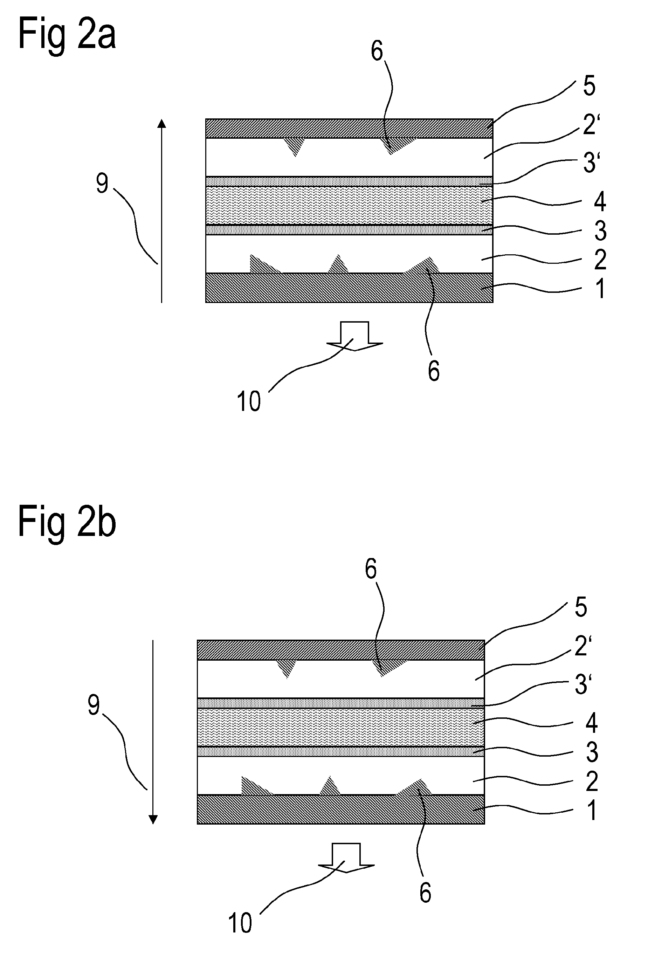

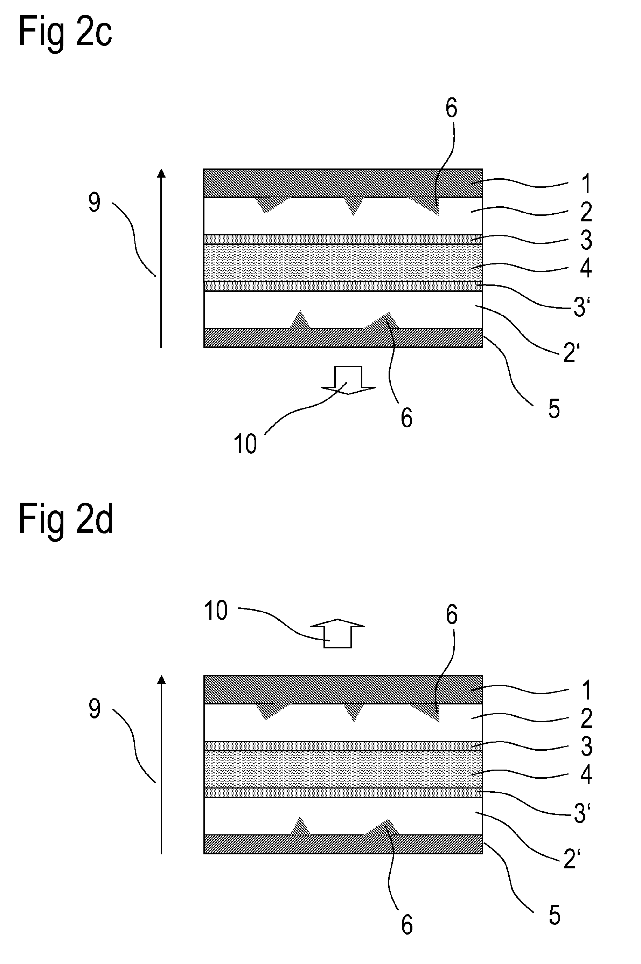

Die Figuren 2a bis d zeigen jeweils einen schematischen Querschnitt von Ausführungsformen der Erfindung, welche gegenüber den Ausführungsformen, wie sie in den Figuren 1a bis d dargestellt sind, zusätzlich noch eine zweite Planarisierungsschicht 2' und eine zweite Injektionsschicht 3' umfassen. Diese können beispielsweise durch die oben genannten Verfahrensschritte F) und G) ausgebildet werden. Die zweite Planarisierungsschicht 2' ist hierbei jeweils zwischen der zweiten Elektrode 5 und der zweiten Injektionsschicht 3' angeordnet. Die zweite Injektionsschicht 3' ist jeweils zwischen der zweiten Planarisierungsschicht 2' und der organischen Funktionsschicht 4 angeordnet.

Bei der organischen Funktionsschicht 4 kann es sich beispielsweise um eine lichtemittierende, ladungsträgerblockende oder ladungsträgertransportierende Schicht oder eine Kombination daraus handeln.

Bei der ersten und/oder der zweiten Elektrode 1,5 kann es sich jeweils unabhängig voneinander um eine gesputterte, thermisch aufgedampfte oder aus Lösung prozessierte Elektrode handeln.

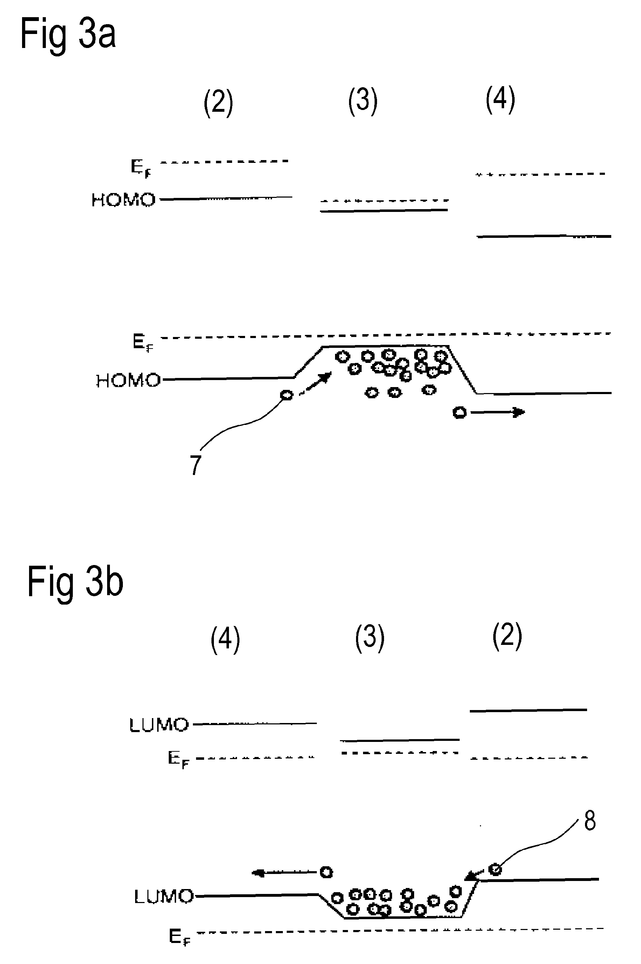

Die Figuren 3a und 3b zeigen jeweils die Energieschemata der ersten Planarisierungsschicht 2 der darauf folgenden ersten Injektionsschicht 3 sowie der organischen Funktionsschicht 4. In der oberen Hälfte ist jeweils das Energieschema vor der Kontaktausbildung, und in der unteren Hälfte jeweils das Energieschema nach der Kontaktausbildung der einzelnen Schichten dargestellt. Nach der Kontaktausbildung kommt es im thermodynamischen Gleichgewicht zur Ausbildung eines Potenzialtopfes. Mit $E_F$ ist in den jeweiligen Figuren die Fermienergie gekennzeichnet.

In der Figur 3a sind die jeweiligen Energieniveaus der höchsten besetzten Molekülorbitale (HOMOs) dargestellt. Von der Elektrode, in diesem Fall der Anode, werden von links die Löcher 7 in die erste Planarisierungsschicht 2 abgegeben. Durch die Kontaktausbildung der einzelnen Schichten hat sich in der ersten Injektionsschicht 3 ein Potenzialtopf ausgebildet, in dem die Löcher 7 nun akkumuliert werden können. Aus diesem können sich nun in die darauffolgende organische Funktionsschicht 4 abgegeben werden. Dies stellt eine gleichmäßige und dauerhafte Versorgung der angrenzenden organischen Funktionsschicht 4 mit Löchern 7 sicher, was zur Stabilisierung des Ladungstransports im Bauelement beiträgt.

In der Figur 3b sind nun die Energieniveaus der niedrigsten unbesetzten Molekülorbitale (LUMOs) dargestellt. Hier werden nun von rechts von der Elektrode, in diesem Fall der Kathode, Elektronen 8 in die erste Planarisierungsschicht 2 injiziert. Auch hier kommt es wieder durch die geeignete Auswahl der Materialien zur Ausbildung eines Potenzialtopfes in der ersten Injektionsschicht 3, wodurch sich die Elektronen 8 in dieser sammeln. Aus dem Potenzialtopf heraus können nun die Elektronen 8 in die organische Funktionsschicht 4 abgegeben werden.

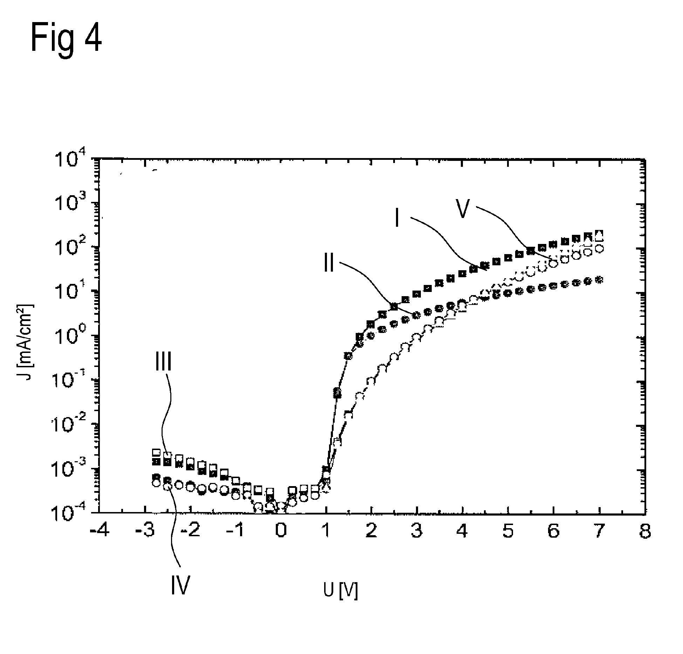

In der Figur 4 sind fünf Strom-Spannungskennlinien (gekennzeichnet mit den römischen Ziffern I bis V) für fünf verschiedene Bauelemente dargestellt. Es ist jeweils die Stromdichte J gegen die angelegte Spannung U aufgetragen. Bei den Bauelementen handelt es sich um Bauelemente mit überwiegend Löchern als Ladungsträger (sogenannte "Hole-only-Bauteile"). Diese weisen den folgenden Aufbau auf: Eine ITO-Anode, eine erste Planarisierungsschicht von 120 nm Dicke, die gleichzeitig als löcherinjizierende Schicht (HIL) dient, gegebenenfalls eine p-dotierte Injektionsschicht von 20 nm Dicke, eine organische Funktionsschicht aus N,N'-Di(naphth-1-yl)-N,N'-diphenyl-benzidin (NPB) von 100 nm Dicke und eine Al-Kathode. Die Bauelemente, für die die Kennlinien I und II aufgenommen wurden, umfassen jeweils keine erste Injektionsschicht, es handelt sich also um nichterfindungsgemäße Bauelemente. Die Bauelemente, für die die Kennlinien III und IV aufgenommen wurden, weisen eine Injektionsschicht auf. Für die Bauelemente der Kennlinien I und III wurden für die erste Planarisierungsschicht und die erste Injektionsschicht jeweils dieselben Polymere gewählt. Entsprechendes gilt für die Bauelemente für die die Kennlinien II beziehungsweise IV aufgenommen wurden. Somit unterscheiden sich die Bauelemente, für die die Kennlinien I und III beziehungsweise II und IV aufgenommen wurden, jeweils nur durch die An- beziehungsweise Abwesenheit der ersten Injektionsschicht. Das Bauelement, für das die Kennlinie V aufgenommen wurde, weist keine erste Planarisierungsschicht sowie keine erste Injektionsschicht auf. Wie der Abbildung zu entnehmen ist, verlaufen die Kennlinien der Bauelemente, welche nur eine Planarisierungsschicht aber keine Injektionsschicht aufweisen recht unterschiedlich, wohingegen die Kennlinien für die Bauelemente mit Planarisierungsschicht und Injektionsschicht in dem Bereich von 1 bis 7 Volt fast deckungsgleich verlaufen.

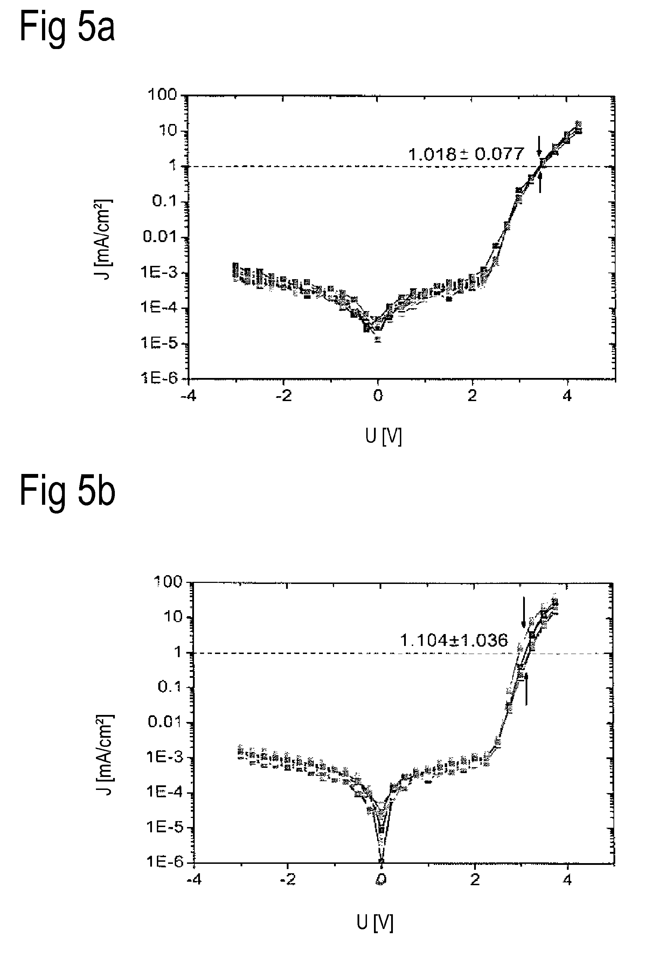

In den Figuren 5a und 5b beziehungsweise 6a und 6b sind die Strom-Spannungskennlinien für jeweils 32 baugleiche Bauelemente übereinander dargestellt. Hierbei ist die Stromdichte J gegen die Spannung U aufgetragen. In jeder Figur ist jeweils die Streuung angegeben, welche an einem bestimmten Messpunkt für die 32 Bauelemente vorliegen. Die vermessenen Bauelemente haben jeweils eine aktive Fläche von 4 $mm^2$. Bei den Bauelementen handelt es sich jeweils um weißemittierende OLEDs.

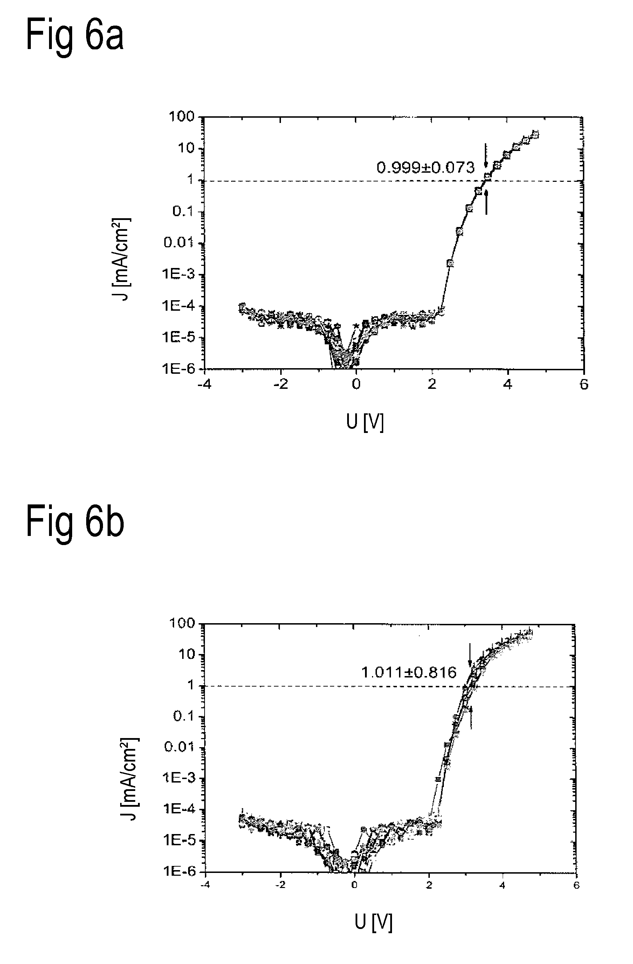

Bei den in den Figuren 5a und 6a dargestellten Bauelementen handelt es sich jeweils um ein Bauelement mit erster Injektions- und Planarisierungsschicht. Sie weisen jeweils den folgenden Aufbau auf: eine ITO-Anode, eine erste Planarisierungsschicht von einer Dicke von 100 nm, eine erste Injektionsschicht von einer Dicke von 20 nm, eine organische Funktionsschicht von einer Dicke von 90 nm und eine Al-Kathode. Die beiden Bauelemente, welche in Figur 5a beziehungsweise Figur 6a vermessen wurden, unterscheiden sich lediglich in dem Polymer, welches für die Planarisierungsschicht und die Injektionsschicht verwendet wurde.

In den Figuren 5b und 6b sind hingegen nicht erfindungsgemäße Bauelemente vermessen worden. Ihr Aufbau wurde gegenüber den in 5a beziehungsweise 6a dargestellten Bauelementen dahingehend verändert, dass anstelle der Kombination von erster Planarisierungsschicht und erster Injektionsschicht lediglich eine Planarisierungsschicht verwendet wurde, welche eine Dicke von 120 nm aufweist. Die Dicke dieser Planarisierungsschicht entspricht somit der Summe aus den Schichtdicken in den Bauelementen aus erster Planarisierungsschicht und erster Injektionsschicht. Für die in den Figuren 5a und 5b vermessenen Bauelemente wurde für die Planarisierungsschicht jeweils das gleiche Polymer verwendet. Entsprechendes gilt ebenfalls für die Bauelemente der Figuren 6a und 6b.

Wie aus den Graphiken deutlich zu erkennen ist weisen die beiden Ausführungsbeispiele in den Figuren 5a und 6a bei einer Stromdichte von etwa 1 mA/$cm^2$ eine deutlich geringere Streuung auf als die jeweils in den Figuren 5b beziehungsweise 6b dargestellten nicht erfindungsgemäßen Bauelemente, welche nicht über die erste Injektionsschicht verfügen. Es ist somit deutlich zu erkennen, dass durch eine gezielte Kombination von erster Planarisierungsschicht mit erster Injektionsschicht die statistische Streuung in dem Strom-Spannungskennlinienverlauf deutlich gesenkt werden kann. Damit weisen die Bauelemente in den Figuren 5a und 6a im Bereich der typischen Betriebspannung zwischen 3V und 4V eine deutlich verbesserte Prozessstabilität auf als die nichterfindungsgemäßen Bauelemente ohne Injektionsschicht.

**Patentansprüche**

1. Optoelektronisches organisches Bauelement, umfassend:

 - eine erste Elektrode (1),
 - eine erste Planarisierungsschicht (2), welche auf der ersten Elektrode (1) angeordnet ist,
 - eine erste Injektionsschicht (3), welche auf der Planarisierungsschicht (2) angeordnet ist,
 - eine organische Funktionsschicht (4), welche auf der Injektionsschicht (3) angeordnet ist,
 - eine zweite Elektrode (5), welche auf der organischen Funktionsschicht (4) angeordnet ist,
 - eine zweite Planarisierungsschicht (2'), welche zwischen der zweiten Elektrode (5) und der organischen Funktionsschicht (4) angeordnet ist,
 - eine zweite Injektionsschicht (3'), welche zwischen der zweiten Planarisierungsschicht (2') und der organischen Funktionsschicht (4) angeordnet ist,

 wobei es sich bei der ersten Elektrode (1) um eine Anode handelt und für die Energieniveaus gilt:

 $$E_F - E_{HOMO,Inj.} \leq E_F - E_{HOMO,Plan.} \text{ und } E_F - E_{HOMO,Inj.} < E_F - E_{HOMO,Funk.},$$

 wobei $E_{HOMO}$ für die Energie des höchsten besetzen Energieniveaus der ersten Planarisierungsschicht, der ersten Injektionsschicht und der organischen Funktionsschicht und $E_F$ für die Fermienergie stehen, wobei die erste Injektionsschicht und die erste Planarisierungsschicht dotiert sind und jeweils das gleiche Matrixmaterial aufweisen, wobei das Matrixmaterial ausgewählt ist aus: PEDOT:PSS, Poly(9-vinylcarbazol), Poly(N,N'-bis(4-butylphenyl)-N,N'-bis(phenyl)-benzidin, Poly(3-hexylthiophen), Polyanilin, wobei die erste Injektionsschicht p-dotiert ist und der Dotierstoff der ersten Injektionsschicht ausgewählt ist aus: $MoO_2$, $MoO_3$, $WO_3$, $ReO_3$, $Re_2O_7$, $V_2O_5$.

2. Optoelektronisches organisches Bauelement nach Anspruch 1, wobei für die Energieniveaus gilt:

 $$E_F - E_{HOMO,Plan.} < E_F - E_{HOMO,Funk.}.$$

3. Optoelektronisches organisches Bauelement nach einem der vorhergehenden Ansprüche, wobei die von der ersten Elektrode (1) abgegebenen Ladungsträger in der ersten Injektionsschicht (3) akkumuliert werden.

4. Optoelektronisches organisches Bauelement nach Anspruch 3, wobei die in der ersten Injektionsschicht (3) akkumulierten Ladungsträger in die darauffolgende Schicht injiziert werden.

5. Optoelektronisches organisches Bauelement nach einem der vorhergehenden Ansprüche, wobei die erste Injektionsschicht (3) eine Schichtdicke von 1 bis 20 nm aufweist.

6. Optoelektronisches organisches Bauelement nach einem der vorhergehenden Ansprüche, wobei die erste Injektionsschicht (3) einen Stoff umfasst ausgewählt aus: 4,4',4"-Tris(N-(1-naphthyl)-N-phenyl-amino)triphenylamin, Phthalocyanin-Kupferkomplex, 4,4',4"-Tris(N-3-methylphenyl-N-phenyl-amino)triphenylamin, N,N'-Bis(naphthalen-1-yl)-N,N'-bis(phenyl)-benzidin, 2,2',7,7'-Tetrakis(N,N-diphenylamin)-9,9'-spirobifluoren, Di-[4-(N,N-ditolyl-amino)-phenyl]cyclohexan, N,N'-Bis(3-methylphenyl)-N,N'-bis(phenyl)-benzidin.

7. Optoelektronisches organisches Bauelement nach einem der vorhergehenden Ansprüche, welches als elektrolumineszierendes Bauelement ausgeformt ist.

8. Verfahren zur Herstellung eines optoelektronischen organischen Bauelements, umfassend die Verfahrensschritte:

A) Bereitstellen einer ersten Elektrode (1),
B) Aufbringen einer ersten Planarisierungsschicht (2) auf die erste Elektrode (1),
C) Aufbringen einer ersten Injektionsschicht (3) auf die erste Planarisierungsschicht (2),
D) Aufbringen einer organischen Funktionsschicht (4) auf die erste Injektionsschicht (3),
E) Aufbringen einer zweiten Elektrode (5) auf die organische Funktionsschicht (4),
F) Aufbringen einer zweiten Injektionsschicht (3') auf die organische Funktionsschicht (4),
G) Aufbringen einer zweiten Planarisierungsschicht (2') auf die zweite Injektionsschicht (3'), wobei die Verfahrensschritte F) und G) vor dem Verfahrensschritt E) ausgeführt werden,

wobei es sich bei der ersten Elektrode (1) um eine Anode handelt und für die Energieniveaus gilt:

$$E_F - E_{HOMO,Inj.} \leq E_F - E_{HOMO,Plan.} \text{ und } E_F - E_{HOMO,Inj.} < E_F - E_{HOMO,Funk.,}$$

wobei $E_{HOMO}$ für die Energie des höchsten besetzen Energieniveaus der ersten Planarisierungsschicht, der ersten Injektionsschicht und der organischen Funktionsschicht steht, $E_F$ für die Fermienergie steht, wobei die erste Injektionsschicht und die erste Planarisierungsschicht dotiert sind und jeweils das gleiche Matrixmaterial aufweisen, wobei das Matrixmaterial ausgewählt ist aus: PEDOT:PSS, Poly(9-vinylcarbazol), Poly(N,N'-bis(4-butylphenyl)-N,N'-bis(phenyl)-benzidin, Poly(3-hexylthiophen), Polyanilin, wobei die erste Injektionsschicht p-dotiert ist und der Dotierstoff der ersten Injektionsschicht ausgewählt ist aus: $MoO_2$ , $MoO_3$, $WO_3$, $ReO_3$, $Re_2O_7$, $V_2O_5$.

**9.** Verfahren nach Anspruch 8,
wobei die erste Injektionsschicht (3) im Verfahrensschritt C) mittel eines nasschemischen Verfahrens aufgebracht wird.

## Claims

**1.** Optoelectronic organic component, comprising:

- a first electrode (1),
- a first planarization layer (2), which is arranged on the first electrode (1),
- a first injection layer (3), which is arranged on the planarization layer (2),
- an organic functional layer (4), which is arranged on the injection layer (3),
- a second electrode (5), which is arranged on the organic functional layer (4),
- a second planarization layer (2'), which is arranged between the second electrode (5) and the organic functional layer (4),
- a second injection layer (3'), which is arranged between the second planarization layer (2') and the organic functional layer (4),

wherein the first electrode (1) is an anode and the following holds true for the energy levels:

$$E_F - E_{HOMO, inj.} \leq E_F - E_{HOMO,plan.} \text{ and } E_F - E_{HOMO, inj.} < E_F - E_{HOMO, func.,}$$

wherein $E_{HOMO}$ denotes the energy of the highest occupied energy level of the first planarization layer, the first injection layer and the organic functional layer and $E_F$ denotes the Fermi energy, wherein the first injection layer and the first planarization layer are doped and each comprise the same matrix material, wherein the matrix material; is selected from: PEDOT:PSS, poly(9-vinylcarbazole), poly(N,N'-bis-(4-butylphenyl)-N,N'-bis(phenyl)benzidine, poly(3-hexylthiophene), polyaniline, wherein the first injection layer is p-doped and the dopant of the first injection layer is selected from: $MoO_2$, $MoO_3$, $WO_3$, $ReO_3$, $Re_2O_7$, $V_2O_5$.

**2.** Optoelectronic organic component according to Claim 1,
wherein the following holds true for the energy levels:

$$E_F-E_{HOMO,plan.} \ < \ E_F-E_{HOMO,func.}$$

3. Optoelectronic organic component according to either of the preceding claims,
wherein the charge carriers emitted by the first electrode (1) are accumulated in the first injection layer (3).

4. Optoelectronic organic component according to Claim 3,
wherein the charge carriers accumulated in the first injection layer (3) are injected into the succeeding layer.

5. Optoelectronic organic component according to any of the preceding claims,
wherein the first injection layer (3) has a layer thickness of 1 to 20 nm.

6. Optoelectronic organic component according to any of the preceding claims,
wherein the first injection layer (3) comprises a substance selected from: 4,4',4''-tris(N-(1-naphthyl)-N-phenyl amino)triphenylamine, phthalocyanine--copper complex, 4,4',4"-tris(N-3-methylphenyl-N-phenylamino)triphenylamine, N,N'-bis(naphthalen-1-yl)-N,N'-bis(phenyl)-benzidine, 2,2',7,7'- tetrakis(N,N-diphenylamine)-9,9'-spirobifluorene, di-[4-(N,N-ditolylamino)-phenyl]cyclohexane, N,N'-bis (3-methylphenyl)- N,N'-bis(phenyl)benzidine.

7. Optoelectronic organic component according to any of the preceding claims,
which is shaped as an electroluminescent component.

8. Method for producing an optoelectronic organic component comprising the following method steps:

A) providing a first electrode (1),
B) applying a first planarization layer (2) to the first electrode (1),
C) applying a first injection layer (3) to the first planarization layer (2),
D) applying an organic functional layer (4) to the first injection layer (3),
E) applying a second electrode (5) to the organic functional layer (4),
F) applying a second injection layer (3') to the organic functional layer (4),
G) applying a second planarization layer (2') to the second injection layer (3'), wherein method steps F) and G) are carried out before method step E) , wherein the first electrode (1) is an anode and the following holds true for the energy levels:

$$E_F-E_{HOMO, inj.} \ \leq \ E_F-E_{HOMO,plan.} \ and \ E_F-E_{HOMO, inj.} \ < \ E_F-E_{HOMO,func.,}$$

wherein $E_{HOMO}$ denotes the energy of the highest occupied energy level of the first planarization layer, the first injection layer and the organic function layer, $E_F$ denotes the Fermi energy wherein the first injection layer and the first planarization layer are doped and each comprise the same matrix material, wherein the matrix material is selected from:

PEDOT:PSS, poly(9-vinylcarbazole), poly(N,N'-bis(4-butylphenyl)-N,N'-bis(phenyl)benzidine, poly(3-hexylthiophene), polyaniline wherein the first injection layer is p-doped and the dopant of the first injection layer is selected from: $MoO_2$, $MoO_3$, $WO_3$, $ReO_3$, $Ry_2O_7$, $V_2O_5$.

9. Method according to Claim 8,
wherein the first injection layer (3) is applied by means of a wet-chemical method in method step C).

**Revendications**

1. Composant optoélectronique organique comprenant :

une première électrode (1),
une première couche de planage (2) disposée sur la première électrode (1),
une première couche d'injection (3) disposée sur la couche de planage (2),
une couche fonctionnelle organique (4) disposée sur la couche d'injection (3),

une deuxième électrode (5) disposée sur la couche fonctionnelle organique (4),
une deuxième couche de planage (2') disposée entre la deuxième électrode (5) et la couche fonctionnelle organique (4),
une deuxième couche d'injection (3') disposée entre la deuxième couche de planage (2') et la couche fonctionnelle organique (4),
la première électrode (1) étant une anode et les niveaux d'énergie satisfaisant les relations :

$$E_F{-}E_{HOMO,Inj.} \leq E_F{-}E_{HOMO,Plan.} \ et \ E_F{-}E_{HOMO,Inj.} < E_F{-}E_{HOMO,Funk.,}$$

dans lesquelles $E_{HOMO}$ représente l'énergie du plus haut niveau occupé de la première couche de planage, de la première couche d'injection et de la couche fonctionnelle organique et $E_F$ représente l'énergie de Fermi, la première couche d'injection et la première couche de planage étant dopées et présentant le même matériau de matrice, le matériau de matrice étant sélectionné parmi le PEDOT:PSS, le poly(9-vinylcarbazole), la poly(N,N'-bis(4-butylphényl)-N,N'-bis(phényl)-benzidine, le poly(3-hexylthiophène) et la polyaniline, la première couche d'injection présentant un dopage p et la substance de dopage de la première couche d'injection étant sélectionnée parmi $MoO_2$, $MoO_3$, $WO_3$, $ReO_3$, $Re_2O_7$ et $V_2O_5$.

2. Composant optoélectronique organique selon la revendication 1, dont les niveaux d'énergie satisfont la relation :

$$E_F{-}E_{HOMO,Plan.} < E_F{-}E_{HOMO,Funk..}$$

3. Composant optoélectronique organique selon l'une des revendications précédentes, dans lequel les porteurs de charge délivrés par la première électrode (1) sont accumulés dans la première couche d'injection (3).

4. Composant optoélectronique organique selon la revendication 3, dans lequel les porteurs de charge accumulés dans la première couche d'injection (3) sont injectés dans la couche suivante.

5. Composant optoélectronique organique selon l'une des revendications précédentes, dans lequel la première couche d'injection (3) présente une épaisseur comprise entre 1 et 20 nm.

6. Composant optoélectronique organique selon l'une des revendications précédentes, dans lequel la première couche d'injection (3) comprend une substance sélectionnée parmi la 4,4',4''-tris(N-(1-naphthyl)-N-phényl-amino)triphénylamine, un complexe de phtalocyanine et de cuivre, la 4,4',4''-tris(N-3-méthylphényl-N-phényl-amino)triphénylamine, la N,N'-bis(naphthalène-1-yl)-N,N'-bis(phényl)benzidine, le 2,2',7,7'-tétrakis(N,N-diphénylamine)-9,9'-spirobufluorène, le di-[4-(N,N-ditolyl-amino)-phényl]cyclohexane et la N,N'-bis(3-méthylphényl)-N,N'-bis(phényl)-benzidine.

7. Composant optoélectronique organique selon l'une des revendications précédentes, configuré comme composant électroluminescent.

8. Procédé de fabrication d'un composant optoélectronique organique, le procédé comportant les étapes qui consistent à :

A) préparer une première électrode (1),
B) appliquer une première couche de planage (2) sur la première électrode (1),
C) appliquer une première couche d'injection (3) sur la première couche de planage (2),
D) appliquer une couche fonctionnelle organique (4) sur la première couche d'injection (3),
E) appliquer une deuxième électrode (5) sur la couche fonctionnelle organique (4),
F) appliquer une deuxième couche d'injection (3') sur la couche fonctionnelle organique (4),
G) appliquer une deuxième couche de planage (2') sur la deuxième couche d'injection (3'), les étapes F) et G) étant exécutées avant l'étape E) du procédé,

la première électrode (1) étant une anode et les niveaux d'énergie satisfaisant les relations :

$$E_F{-}E_{HOMO,Inj.} \leq E_F{-}E_{HOMO,Plan.} \ et \ E_F{-}E_{HOMO,Inj.} < E_F{-}E_{HOMO,Funk.,}$$

dans lesquelles $E_{HOMO}$ représente l'énergie du plus haut niveau occupé de la première couche de planage, de la première couche d'injection et de la couche fonctionnelle organique et $E_F$ représente l'énergie de Fermi,
la première couche d'injection et la première couche de planage étant dopées et présentant le même matériau de matrice, le matériau de matrice étant sélectionné parmi le PEDOT:PSS, le poly(9-vinylcarbazole), la poly(N,N'-bis(4-butylphényl)-N,N'-bis(phényl)-benzidine, le poly(3-hexylthiophène) et la polyaniline,
la première couche d'injection présentant un dopage p et la substance de dopage de la première couche d'injection étant sélectionnée parmi $MoO_2$, $MoO_3$, $WO_3$, $ReO_3$, $Re_2O_7$ et $V_2O_5$.

9. Procédé selon la revendication 8, dans lequel la première couche d'injection (3) est appliquée au cours de l'étape C) du procédé au moyen d'un procédé chimique en conditions humides.

# Fig 1a

# Fig 1b

Fig 1c

Fig 1d

Fig 2a

Fig 2b

## Fig 2c

## Fig 2d

# Fig 3a

# Fig 3b

# Fig 4

# Fig 5a

# Fig 5b

## Fig 6a

## Fig 6b